Europäisches Patentamt

European Patent Office

Office européen des brevets

(19)

(11) Veröffentlichungsnummer: **0 111 063**
**B1**

(12) **EUROPÄISCHE PATENTSCHRIFT**

(45) Veröffentlichungstag der Patentschrift:
26.02.86

(51) Int. Cl.⁴: **H 01 F 40/06**

(21) Anmeldenummer: **83108860.4**

(22) Anmeldetag: **08.09.83**

(54) Stromteiler für Messwandler.

(30) Priorität: **28.10.82 CH 6287/82**

(43) Veröffentlichungstag der Anmeldung:
**20.06.84 Patentblatt 84/25**

(45) Bekanntmachung des Hinweises auf die Patenterteilung:
**26.02.86 Patentblatt 86/9**

(84) Benannte Vertragsstaaten:
**AT DE FR GB IT NL**

(56) Entgegenhaltungen:
**DE - A - 1 515 736**
**DE - A - 3 008 308**
**DE - B - 1 133 817**
**US - A - 2 831 164**
**US - A - 4 240 059**

(73) Patentinhaber: **LGZ LANDIS & GYR ZUG AG,**
**CH-6301 Zug (CH)**

(72) Erfinder: **de Vries, Jacob, Feldbergstrasse 2,**
**CH-6311 Allenwinden (CH)**

## Beschreibung

Die Erfindung bezieht sich auf einen Stromteiler für Messwandler nach dem Oberbegriff des ersten Patentanspruches.

Solche Stromteiler sind in der DE-A- 30 08 308 beschrieben. Der zu messende Strom wird mit Hilfe eines Stromleiters, der sich in der Stromflussrichtung in zwei Strompfade teilt, in einen Messstrom und einen Nebenschlussstrom aufgeteilt. Nur der durch den Messpfad fliessende Strom im eigentlichen Messwandler wird ausgewertet. Der Nebenschlusspfad sowie der Messpfad sind räumlich so weit voneinander entfernt angeordnet, dass sie beim Betrieb unterschiedlich erwärmt bzw. gekühlt werden. Demzufolge sind keine isothermischen Bedingungen vorhanden, wie sie zur Unterdrückung des durch die Wärmebeeinflussung entstehenden Messfehlers, welcher bekanntlich mit dem Ansteigen des zu messenden Stromes zunimmt, erforderlich wären.

Aus der US-A 4 240 059 ist ein Stromteiler bekannt, dessen zwei halbkreisförmige, einen kreisförmigen leitenden Pfad bildende Hauptstrompfade durch einen Messstrompfad verbunden sind. Die Anschlusspunkte des Messstrompfades mit den Hauptstrompfaden weisen leicht unterschiedliche Potentiale auf, so dass durch den Messstrompfad ein vorbestimmter Teil des gesamten zu messenden Stromes fliesst. Durch die Veränderung der Lage des Messstrompfades kann der vom Potentialunterschied der Anschlusspunkte abhängige Teilstrom variiert werden. Auch bei dieser Lösung sind die isothermischen Bedingungen wegen schlechter Kopplung der einzelnen Teile des Messpfades nicht vorhanden. Ausserdem sind bei solchen Lösungen mit Rücksicht auf den kleinen Widerstand des Messstrompfades kompensierte Messwandler erforderlich.

Der vorliegenden Erfindung liegt die Aufgabe zugrunde, einen Stromteiler für Messwandler zu schaffen, bei welchem die angeführten Nachteile der bekannten Lösungen weitgehend beseitigt sind.

Die gestellte Aufgabe ist beim Stromteiler der angeführten Gattung durch Merkmale des ersten bzw. des zweiten Patentanspruches gelöst.

Die Erfindung wird nachfolgend anhand einer Zeichnung näher erläutert.

Es zeigen:

Fig. 1 — den Stromteiler in perspektivischer Sicht,

Fig. 2 — die Ansicht der Innenseiten des in eine Ebene abgewickelte Stromteilers gemäß Fig. 1, und

Fig. 3 — eine einfachere Ausführung des Stromteilers in Draufsicht.

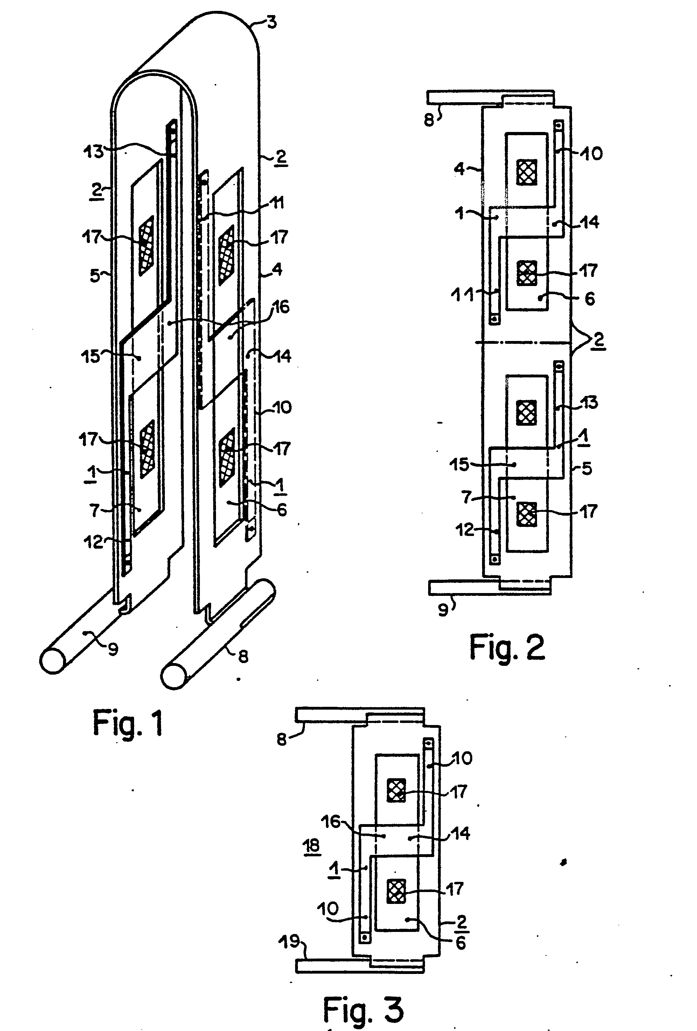

Der erfindungsgemässe Stromteiler zum potentialfreien Messen von Strömen gemäss den Figuren 1 und 2 weist einen aus einem Messstrompfad 1 und aus einem Nebenschluss 2 bestehenden Strompfad auf. Der Nebenschluss 2 besteht aus einem flachen Leiter und hat im vorliegenden Ausführungsbeispiel die Form des Buchstabens U mit zwei durch einen gebogenen Teil 3 verbundenen parallel verlaufenden Schenkeln 4, 5. Diese Schenkel 4, 5 sind in der Zeichnung weit voneinander gezeichnet, um die Anordnung des Messpfades deutlich zeigen zu können. In Wirklichkeit liegen die Schenkel 4, 5, getrennt durch eine n icht gezeichnete Isolierschicht, dicht nebeneinander. Jeder mit einer Oeffnung 6, 7 versehene Schenkel 4, 5 ist mit einer Stromschiene 8, 9 für die Zuleitung des gesamten Stromes verbunden. Der Messstrompfad 1 ist durch zwei Z-förmige Messleiter mit zu den Schenkeln 4, 5 parallelen Leitern 10, 11, 12, 13 und mit je einem Querteil 14 und 15 gebildet, die an den Innenwänden der Schenkel 4, 5 so angebracht sind, dass die Querteile 14, 15 jeweils über der Oeffnung 6 bzw. 7 liegen.

Die Enden der Leiter 10, 11; 12, 13 sind mit den Schenkeln 4, 5 elektrisch verbunden. Diese Verbindung ist so zu gestalten, dass deren Uebergangswiderstand das Teilungsverhältnis nicht beeinflusst. Zwischen den Messleitern einerseits und zwischen diesen und den Schenkeln 4, 5 anderseits ist je eine Isolierschicht vorgesehen. Der Querschnitt der Querteile 14, 15 ist grösser als der Querschnitt der Leiter 10 11; 12 13. Die Querteile 14 15 bilden über den Oeffnungen 6, 7 des Nebenschlusses 2 einen Steg 16, welcher in den Oeffnungen 6, 7 der Schenkel 4, 5 vom Kern 17 eines nicht gezeichneten Messwandlers üblicher Ausführung umgeben ist.

Es ist von Vorteil, wenn die Leiter 10, 11; 12, 13 der Messleiter, wie in den Fig. 1 und 2 gezeigt, gleich lang sind, so dass der Kern 17 des Messwandlers symmetrisch, das heisst in der Mitte zwischen den beiden Enden der Messleiter angeordnet werden kann. Durch eine solche Anordnung werden die Einflüsse der magnetischen Aussenfelder weitgehend beseitigt.

Die beiden Schenkel 4, 5 des Nebenschlusses 2 können als zwei getrennte.Teile hergestellt werden, die dann anstatt durch den gebogenen Teil 3 z.B. durch Schrauben u. dgl. verbunden sind.

Der gesamte zu messende, den Stromschienen 8, 9 zugeführte Strom wird im Verhältnis der Widerstände des Messstrompfades 1 und des Nebenschlusses 2 geteilt. Alle Teile des Stromteilers weisen während des Betriebes im wesentlichen die gleiche Temperatur auf, was durch die gedrängte Bauweise mit guter thermischer Kopplung der einzelnen Teile ermöglicht wird. Die isothermischen Bedingungen für die Herabsetzung des durch unterschiedliche Temperatur einzelner Tei le hervorgerufenen Messfeh lers sind dabei optimal erfüllt. Der kleine Widerstand der breiten. Querteile 14, 15 und somit des Steges 16 hat wenig Einfluss auf das Teilungsverhältnis des Stromteilers. Der Widerstand des Messpfades ist so gross, so dass er es möglich macht für die Auswertung des gemessenen Stromes einen Messwandler üblicher, d.h. nicht kompensierter Ausführung zu verwenden.

Durch die Veränderung der Abmessungen der Messleiter kann der gesamte Widerstand des Stromteilers variiert werden. Durch die symmetrische Anordnung des Kerns 17 sind die Einflüsse der magnetischen Aussenf leder weitgehend beseitigt.

Eine einfachere Ausführung des Stromteilers ist aus der Fig. 3 ersichtlich. Der Nebenschluss ist hier lediglich durch einen im wesentlichen einem der Schenkel 4 oder 5 gemäss den Figuren 1 und 2 entsprechenden Schenkel 18 gebildet. In der weiteren Beschreibung wird vom Schenkel 4 ausgegangen, wobei die gleichen Teile mit gleichen Bezugszeichen bezeichnet sind. Zum Unterschied zum Schenkel 4 ist der Schenkel 18 auch auf dem anderen Ende mit einer Stromschiene 19 versehen, die gemeinsam mit der Stromschiene 8 für die Zuleitung des gesamten zu messenden Stromes dient. Alle anderen Bestandteile, das heisst der durch eine Isolierschicht vom Schenkel 18 getrennte Z-förmige Messleiter mit den parallelen Leitern 10, 11, deren Enden mit dem Schenkel 18 elektrisch verbunden sind, und mit dem Querteil 14, sind gleich wie beim Schenkel 4. Der Querteil 14 bildet auch hier den Steg 16, welcher in der Oeffnung 6 des Schenkels 18 vom Kern 17 eines nicht gezeichneten Messwandlers üblicher Ausführung umgeben ist. Der Querteil 14 weist einen grösseren Querschnitt als die Leiter 10, 11 auf. Es ist auch hier von Vorteil, wenn die Leiter 10, 11 gleich lang sind, so dass der Kern 17 symmetrisch zwischen den Enden des Messleiters angeordnet werden kann.

**Patentansprüche**

1. Stromteiler für Messwandler zum potentialfreien Messen von Strömen, bestehend aus einem Stromleiter mit zwei Strompfaden, von denen der eine Strompfad (1) den zu messenden Teilstrom führt und der andere Strompfad einen Nebenschluss (2) bildet, dadurch gekennzeichnet, dass der Nebenschluss (2) aus einem flachen Leiter mit parallel verlaufenden Schenkeln (4, 5) besteht, dass der den zu messenden Teilstrom führende Messstrompfad (1) durch Z-förmige Messleiter mit zu den Schenkeln (4, 5) parallelen Leitern (10, 11; 12, 13) und mit je einem Querteil (14, 15) gebildet ist, die an den Innenwänden der Schenkel (4, 5) angeordnet und mit den Enden der Leiter (10, 11; 12, 13) mit den Schenkeln (4, 5) elektrisch verbunden sind, und dass die Querteile (14, 15) einen Steg (16) bilden, welcher in, in den Schenkeln (4, 5) vorgesehenen Oeffnungen (6, 7) mit einem Kern (17) eines Messwandlers umgeben ist.

2. Stromteiler nach dem ersten Teil des Anspruches 1, dadurch gekennzeichnet, dass der Nebenschluss (2) aus einem durch einen flachen Leiter gebildeten Schenkel (18) besteht, dass der den zu messenden Teilstrom führende Messstrompfad (1) durch einen Z-förmigen Messleiter mit zu dem Schenkel (18) parallelen Leitern (10, 11) und mit einem Querteil (14) gebildet ist, der an einer Wand des Nebenschlusses (2) angeordnet und mit den Enden der Leiter (10, 11) mit dem Schenkel (18) elektrisch verbunden ist, und dass der Querteil (14) einen Steg (16) bildet, welcher in, in einer im Schenkel (18) vorgesehenen Oeffnung (6) mit einem Kern (17) eines Messwandlers umgeben ist.

3. Stromteiler nach Anspruch 1 oder 2, dadurch gekennzeichnet, dass die Leiter (10, 11; 12, 13) der Messleiter gleich lang sind, so dass der Steg (16) mit dem Kern (17) symmetrisch und somit in der Mitte zwischen den beiden Enden der Messleiter angeordnet ist.

4. Stromteiler nach Anspruch 1, dadurch gekennzeichnet, dass der Nebenschluss (2) aus separaten Schenkeln (4,5) besteht, deren Enden entweder über einen gebogenen Teil (3) oder durch Schrauben verbunden sind.

5. Stromteiler nach Anspruch 1 oder 2, dadurch gekennzeichnet, dass der Steg (16) einen grösseren Querschnitt als die Leiter (10, 11; 12, 13) aufweist.

**Claims**

1. A current divider for measuring transformers for the potentialfree measurement of currents, ccmprising a current conductor with two current paths of which one current path (1) carries the current component to be measured and the other current path forms a shunt (2) characterised in that the shunt (2) comprises a flat conductor with limb portions (4, 5) which extend in parallel relationship, that the measuring current path (1) which carries the current component to be measured is formed by Z-shaped measuring conductors with conductors (10, 11; 12, 13) parallel to the limb portions (4, 5) and with a respective transverse portion (14, 15), which are disposed at the inside surfaces of the limb portions (4, 5) and are electrically connected with the ends of the conductors (10, 11; 12, 13) to the limb portions (4, 5) and that the transverse portions (14, 15) form a web portion (16) which, in openings (6, 7) provided in the limb portions (4, 5), is surrounded with a core (17) of a measuring transformer.

2. A current divider according to the first part of claim 1 characterised in that the shunt (2) comprises a limb portion (18) formed by a flat conductor, that the measuring current path (1) which carries the current component to be measured is formed by a Z-shaped measuring conductor with conductors (10, 11) which are parallel to the limb portion (18) and with a transverse portion (14) which is disposed on a wall of the shunt (2) and is electrically connected with the ends of the conductors (10, 11) to the limb portion (18) and that the transverse portion (14) forms a web portion (16) which, in an opening (6) provided in the limb portion (18), is surrounded with a core (17) of a measuring transformer.

3. A current divider according to claim 1 or claim 2 characterised in that the conductors (10, 11; 12, 13) of the measuring conductors are of equal length so that the web portion (16) is arranged with the core (17) symmetrically and thus centrally between the two ends of the measuring conductors.

4. A current divider according to claim 1 characterised in that the shunt comprises separate limb portions (4,

3

5), the ends of which are connected either by way of a bent portion (3) or by screws.

5. A current divider according to claim 1 or claim 2 characterised in that the web portion (16) is of larger cross-section than the oonductors (10,.11; 12, 13).

## Revendications

1. Diviseur de courant pour transformateur de mesure de courants sans potentiel constitué par un conducteur à deux circuits de courant, dont un (1) est parcouru par le courant partiel à mesurer et dont l'autre forme un shunt (2), ledit diviseur étant caractérisé en ce que le shunt (2) est constitué par un conducteur plat à branches parallèles (4, 5); le circuit de mesure (1) parcouru par le courant partiel à mesurer est constitué par des conducteurs de mesure en Z comportant chacun des conducteurs (10, 11; 12, 13) parallèles aux branches (4, 5) et une partie transversale (14, 15) qui est disposée sur la paroi intérieure des branches (4, 5) et reliée électriquement avec les extrémités des conducteurs (10, 11; 12, 13) et les branches (4,5); et les parties transversales (14, 15) formentune entretoise (16) qui, dans les ouvertures (6, 7) prévues dans les branches (4, 5), est entourée par un noyau (17) d'un transformateur de mesure.

2. Diviseur de courant selon le préambule de la revendication 1, caractérisé en ce que le shunt (2) est constitué par une branche (18) formée par un conducteur plat; le circuit de mesure (1) parcouru par le courant partiel à mesurer est constitué par un conducteur de mesure en Z comportant des conducteurs (10, 11) parallèles à la branche (18) et une partie transversale (14) disposée sur une paroi du shunt (2) et reliée aux extrémités des conducteurs (10, 11) et à la branche (18); et la partie transversale (14) forme une entretoise (16) qui, dans l'ouverture (6) prévue dans la branche (18), est entourée par un noyau (17) d'un transformateur de mesure.

3. Diviseur de courant selon une des revendications 1 ou 2, caractérisé en ce que les conducteurs (10, 11; 12, 13) des conducteurs de mesure sont de même longueur, de sorte que l'entretoise (16) est disposée svec le noyau (17) symétrique, c'est-à-dire au centre entre les deux extrémités des conducteurs de mesure.

4. Diviseur de courant selon revendication 1, caractérisé en ce que le shunt (2) est constitué par des branches séparées (4, 5) dont les extrémités sont reliées soit par une partie coudée (3), soit par des vis.

5. Diviseur de courant selon une des revendications 1 ou 2, caractérisé en ce que la section de l'entretoise (16) est supérieure à celle des conducteurs (10, 11; 12, 13).

Fig. 1

Fig. 2

Fig. 3